# EUROPEAN PATENT APPLICATION

(11) **EP 4 444 049 A1**
(43) Date of publication of application: **09.10.2024**
(21) Application number: 22901019.4
(22) Date of filing: 04.11.2022
(51) Int. Cl.: H05K 3/46

(54) **MULTILAYER WIRING BOARD MANUFACTURING METHOD, AND MULTILAYER WIRING BOARD**

(30) Priority: 30.11.2021 JP 2021194330
(71) Applicant: Toppan Holdings Inc., Tokyo 110-0016 (JP)
(72) Inventor: SAWADAISHI, Masashi, Tokyo 110-0016 (JP)
(74) Representative: Plasseraud IP
(86) International application number: PCT/JP2022/041103
(87) International publication number: WO 2023/100586

(57) **Abstract**

When modified layers are formed in part of the inside of a glass substrate by laser irradiation, it is very difficult to control the modification depth. Therefore, if the through holes are formed by etching the modified portions, variations may occur in the depth direction and radial direction. The present invention is a method of producing a multilayer wiring board including a glass substrate having through holes, the glass substrate having a first surface and a second surface, the method including: a first step of adhering a support to the second surface of the glass substrate; a second step of forming modified portions in the glass substrate and the support by laser irradiation; a third step of releasing and removing the support; and a fourth step of forming through holes in the glass substrate by etching.

## Description

### [Technical Field]

The present invention relates to methods of producing multilayer wiring boards, and multilayer wiring boards.

### [Background Art]

In recent years, as electronic devices have become more sophisticated and compact, multilayer wiring boards such as interposers mounted on electronic devices have been required to be even more precise.

In particular, recent multilayer wiring boards use a glass substrate, and through holes are formed in the glass substrate to provide through-electrodes. In the multilayer wiring boards, a conductor layer, an insulating resin layer, and a conductor layer are sequentially laminated on both sides of the glass substrate.

However, when the glass substrate has a glass thickness of approximately 100 µm, problems such as cracking are likely to occur in the glass substrate during production of the multilayer wiring board.

Therefore, in order to prevent occurrence of such cracking, PTL 1 adopts the steps of adhering a support to the glass substrate via a release layer and releasing the support after wiring is formed.

Specifically, PTL 1 adopts a step of forming a first wiring on a first surface of the glass substrate, a step of supporting the first wiring-side of the glass substrate on which the first wiring is formed with a support, a step of forming laser-modified portions that serve as starting points of through holes by irradiating a surface of the glass substrate facing away from the first surface with a laser, a step of forming through holes by performing etching using a hydrogen fluoride etching solution on the glass substrate from the surface facing away from the first surface toward the first surface while thinning the glass substrate, a step of forming through-electrodes inside the through holes after the step of forming through holes, a step of forming a second wiring on a surface of the glass substrate facing away from the first surface and connecting the first wiring and the second wiring to each other via the through-electrodes, and a step of removing the support from the glass substrate after the step of forming a second wiring.

### [Citation List]

### [Patent Literature]

PTL 1: WO 2019/235617 A

### [Summary of Invention]

### [Technical Problem]

Although the laser-modified portions can be formed by irradiating a part of the glass substrate with a laser, it is difficult to control modification depth when the modified layers are formed in part of the inside of the glass substrate. This may cause variations in depth direction of the modified portions.

As a result, in formation of through holes by etching, variations may occur in the diameters of the through holes.

In view of the above problems, the present invention has been made to provide techniques for forming through holes with high precision in a method of producing a multilayer wiring board which includes forming laser-modified portions in a core material of the multilayer wiring board and then forming through holes by etching.

### [Solution to Problem]

One of the representative methods of the present invention for producing a multilayer wiring board including a glass substrate having through holes, the glass substrate having a first surface and a second surface, the method including:
a first step of adhering a support to the second surface of the glass substrate;
a second step of forming modified portions in the glass substrate and the support by laser irradiation;
a third step of releasing and removing the support; and
a fourth step of forming through holes in the glass substrate by etching.

### [Advantageous Effects of Invention]

According to the present invention, since the modified portions are formed in both the core material and the first support, the modified portions can be uniformly formed in the glass substrate. Then, by performing etching, the through holes can be formed with high precision.

Problems, configurations and effects other that those described above will be apparent from the description of embodiments below.

### [Brief Description of Drawings]

Fig. 1 is a cross-sectional view illustrating a step of adhering a first support to a glass substrate.
Fig. 2 is a cross-sectional view illustrating a step of forming laser-modified portions.
Fig. 3 is a cross-sectional view illustrating a step of forming a first wiring layer.
Fig. 4 is a cross-sectional view illustrating a step of adhering a second support.
Fig. 5 is a cross-sectional view illustrating a step of releasing a first support.
Fig. 6 is a cross-sectional view illustrating a step of forming through holes by etching.
Fig. 7 is a cross-sectional view illustrating a step of forming a second wiring layer.
Fig. 8 is a cross-sectional view illustrating a step of releasing a second support.
Fig. 9 is a cross-sectional view of a glass substrate with wiring layers formed on both sides.
Fig. 10 is a cross-sectional view illustrating a step of forming a build-up layer.
Fig. 11 is a cross-sectional view of a completed multilayer wiring board.
Fig. 12 is a cross-sectional view illustrating a step of forming a wiring layer in a second embodiment.
Fig. 13 is a cross-sectional view illustrating a step of forming laser-modified portions in the second embodiment.
Fig. 14 is a cross-sectional view illustrating a step of adhering a second support in a third embodiment.
Fig. 15 is a cross-sectional view illustrating a step of forming laser-modified portions in the third embodiment.
Fig. 16 is a cross-sectional view of a multilayer wiring board produced in the first to third embodiments.
Fig. 17 is a cross-sectional view of a multilayer wiring board produced in the first to third embodiments.
Fig. 18 is a cross-sectional view illustrating the shape of a through hole produced in the first to third embodiments.
Fig. 19 is a cross-sectional view of a glass multilayer wiring board for passive components with built-in capacitor structures.
Fig. 20 is a cross-sectional view of a structure in which an interposer on which a plurality of semiconductor elements are mounted is mounted on a BGA substrate.

### [Description of Embodiments]

With reference to the drawings, some embodiments of the present invention will be described.

It should be noted that the description below relates to examples of the present invention, and the invention is not limited by these examples. In the following description of the drawings, the same components are denoted by the same reference signs.

In order to facilitate understanding of the invention, the position, size, shape, range, and the like of each component shown in the drawings may not represent the actual position, size, shape, range, and the like. Therefore, the present invention is not necessarily limited to the position, size, shape, range, and the like disclosed in the drawings.

The "surface" described herein may refer not only to a surface of a plate-like member, but also to an interface of layers included in the plate-like member, the layers being substantially parallel to the surface of the plate-like member. Further, the "upper surface" and "lower surface" refer to surfaces shown on the upper side and lower side of the plate-like member or the layers included in the plate-like member as viewed in the drawings. In addition, the "upper surface" and "lower surface" may also be called "first surface" and "second surface", respectively.

The "side surface" refers to a portion extending across the thickness of the surface or layer of the plate-like member or the layers included in the plate-like member. Further, a part of the surface and the side surface may also be collectively referred to as an "end portion".
"Upper" refers to the upper side in the vertical direction when the plate-like member or the layers are placed horizontally. Further, "upper" and "lower" may also be referred to as the "positive Z-axis direction" and "negative Z axis direction", respectively, which are opposite directions, and the horizontal direction may also be referred to as "X axis direction" or "Y axis direction".

The "planar shape" and "plan view" refer to the shape when the surface or layer is viewed from above. Further, the "cross-sectional shape" and "cross-sectional view" refer to the shape as viewed in the horizontal direction when the plate-like member or the layers are cut in a specific direction.

The "center portion" refers to a center portion other than the peripheral portion of the surface or layer. The "center direction" refers to a direction from the peripheral portion of the surface or layer toward the center of the planar shape of the surface or layer.

### <First Embodiment>

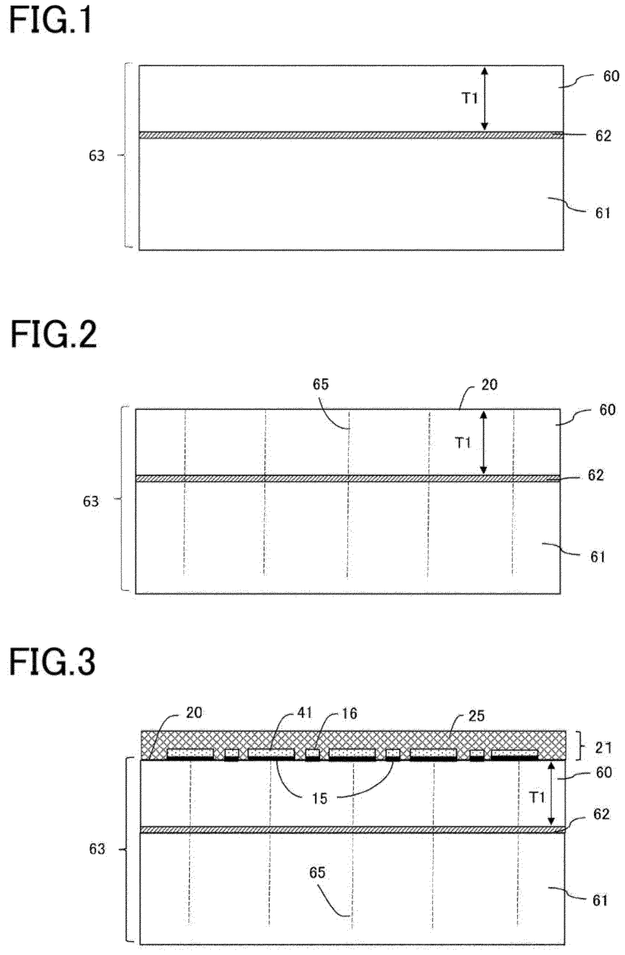

With reference to Figs. 1 to 11, a method of producing a multilayer wiring layer in a first embodiment will be described.

### (Adhesion of First Support)

First, referring to Fig. 1, a step of adhering a first support 61 to a glass substrate 60 will be described.

As shown in Fig. 1, the first support 61 is bonded to the glass substrate 60 using a first adhesive layer 62 to form a laminate structure 63 composed of the glass substrate 60, the first adhesive layer 62 and the first support 61.

The first adhesive layer 62 is for temporary fixation of the first support 61 to the glass substrate 60. Therefore, the material of the first adhesive layer 62 can be appropriately selected from resins that become releasable by heat generation, sublimation or alteration when absorbing light such as UV light, resins that become releasable by foaming due to heat, resins that become releasable due to the presence of functional groups, and the like.

The first support can be bonded to the glass substrate 60 using, for example, a laminator, a vacuum pressure press, a vacuum laminator, or the like.

The first support 61 is preferably made of the same material as that of the glass substrate 60. When the glass substrate 60 is made of alkali-free glass, the first support 61 is also preferably made of alkali-free glass. Further, the thickness of the first support can be appropriately set according to the thickness of the glass substrate 60. However, the thickness is preferably a thickness that can be transported during production steps, and ranges from 300 µm to 1,500 µm.

### (Formation of Laser-Modified Portions)

Next, referring to Fig. 2, a step of forming laser-modified portions will be described. As shown in Fig. 2, the laminate structure 63 is irradiated with a laser to form laser-modified portions 65 that serve as starting points of through holes. The laser-modified portions 65 may extend, for example, in a direction perpendicular to the glass substrate 60, and can be formed substantially over the entire surface of the glass substrate 60. Here, the laser-modified portions 65 may also be formed in the first adhesive layer 62 and the first support 61.

In the present embodiment, by irradiating the glass substrate 60 on which the first support 61 is laminated, it is possible to widen the process window for laser irradiation and reliably form desired laser-modified portions in the glass substrate 60.

### (Formation of First Wiring Layer)

Next, referring to Fig. 3, a step of forming a first wiring layer 21 will be described. As shown in Fig. 3, the first wiring layer 21 including a conductive layer and an insulating resin layer is formed on a first surface 20, which is an upper surface of the glass substrate 60 of the laminate structure 63. Specifically, after a seed layer including a hydrofluoric acid resistant metal layer 15 is formed on the glass substrate 60, through-electrode connecting sections 41 and wirings 16 between the through-electrodes are formed on the first surface 20 by a semi-additive process (SAP), and an unnecessary seed layer is removed to thereby form an insulating resin layer 25.

The hydrofluoric acid resistant metal layer 15 on the glass substrate 60 is an alloy layer made of chromium, nickel or both, and can be formed by sputtering in the range of 10 nm to 1,000 nm. Then, a conductive metallic film is formed on the hydrofluoric acid resistant metal at a desired thickness. The conductive metallic film may be appropriately selected from, for example, Cu, Ni, Al, Ti, Cr, Mo, W, Ta, Au, Ir, Ru, Pd, Pt, AlSi, AlSiCu, AlCu, NiFe, ITO, IZO, AZO, ZnO, PZT, TiN and Cu₃N₄.

In formation of the first wiring layer by a semi-additive process, a photoresist can be used to form a desired pattern. A dry film resist is typically used, but a liquid resist may be used. After the desired pattern is formed by exposure and development, a plating film of 2 µm or greater and 20 µm or less is formed by electrolytic plating, unnecessary resist pattern is removed, and the seed layer is etched to thereby form wirings.

The insulating resin layer 25 is a material containing at least one of epoxy resin, polyimide resin and polyamide resin, and containing fillers such as silica, titanium oxide and urethane, and is preferably a material in the form of liquid or film. A liquid resin can be applied by spin coating, and a film resin can be applied by heating and pressurizing under vacuum using a vacuum laminator. The material of the insulating resin layer 25 can be appropriately selected as necessary.

### (Adhesion of Second Support)

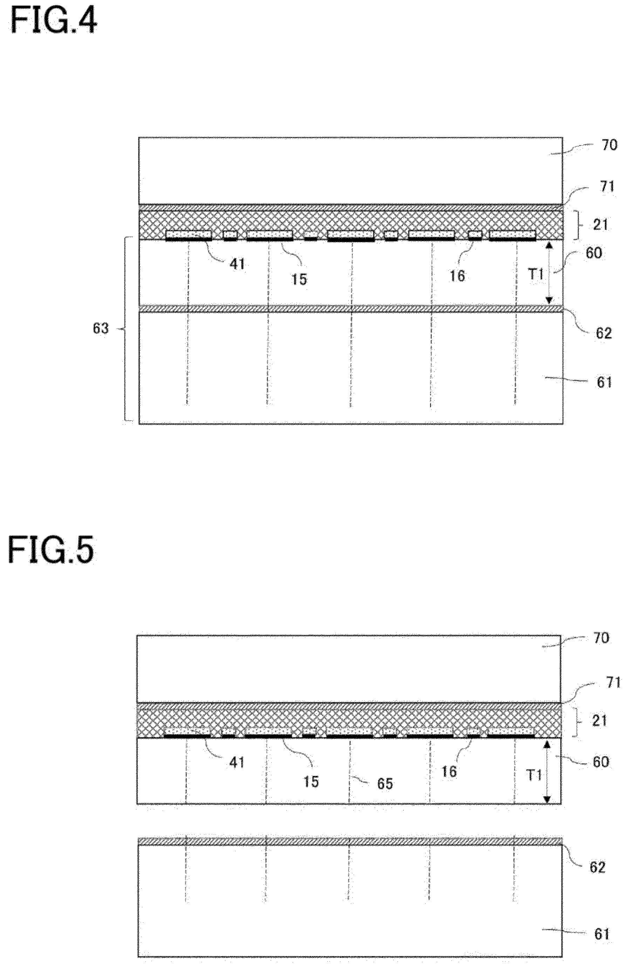

Next, referring to Fig. 4, a step of adhering a second support will be described. As shown in Fig. 4, a second adhesive layer 71 and a second support 70 are formed on the first wiring layer 21 of the laminate structure 63.

The material of the second adhesive layer 71 can be appropriately selected, as with the first adhesive layer 62, from resins that become releasable by heat generation, sublimation or alteration when absorbing light such as UV light, resins that become releasable by foaming due to heat, resins having functional groups that temporarily fix the glass substrate 60 to the first support 61, and the like, but is preferably different from the material of the first adhesive layer 62.

The second support 70 is preferably made of glass, and the same material as that of the glass substrate 60. When the glass substrate 60 is made of alkali-free glass, the first support 61 is also preferably made of alkali-free glass. Further, the thickness of the second support can be appropriately set according to the thickness of the glass substrate 60. However, the thickness is preferably a thickness that can be transported, and ranges from 300 µm to 1,500 µm.

### (Release of First Support)

Next, referring to Fig. 5, a step of releasing the first support will be described. As shown in Fig. 5, the first adhesive layer 62 and the first support 61 are released from the interface between the glass substrate 60 and the first adhesive layer 62.

In release of the first support 61 from the interface between the glass substrate 60 and the first adhesive layer 62, an appropriate release method is selected from UV light irradiation, heating, physical release, and the like depending on the material used for the first adhesive layer. Further, when residues of the first adhesive layer 62 are present on the bonding surface between the glass substrate 60 and the first adhesive layer 62, plasma cleaning, ultrasonic cleaning, water cleaning, solvent cleaning using alcohol, or the like may be performed.

### (Through Hole Formation by Etching)

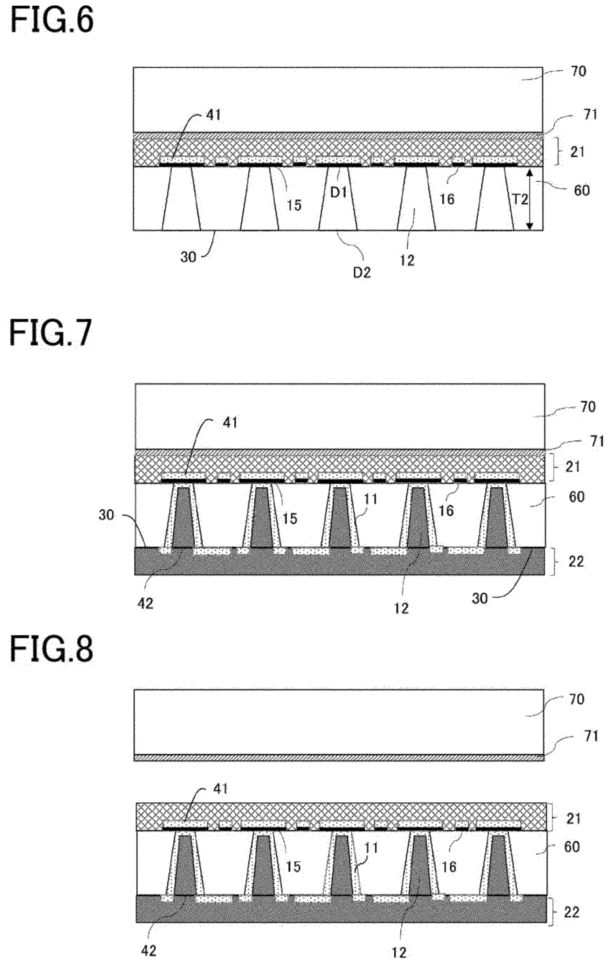

Next, with reference to Fig. 6, a step of forming through holes by etching will be described. As shown in Fig. 6, the laser-modified portions 65 of the glass substrate 60 are selectively removed by etching to form through holes 12 from the surface on the lower side in the figure. Wet etching with a hydrogen fluoride aqueous solution is suitable for the etching. The amount of etching with hydrogen fluoride aqueous solution is appropriately set according to the thickness of the glass multilayer wiring board. For example, when the glass substrate 60 has a thickness T1 of 200 µm, the amount of etching is preferably in the range of 50 µm or greater and 175 µm or less.

A thickness T2, which is the thickness of the etched glass substrate 60, is preferably in the range of 25 µm or greater and 150 µm or less.

### (Formation of Second Wiring Layer)

Next, referring to Fig. 7, a step of forming a second wiring layer will be described. As shown in Fig. 7, a second wiring layer 22 including a conductive layer and an insulating resin layer is formed on a second surface 30 on a lower side of the glass substrate 60. In formation of the through holes 12 and the second wiring layer on the second surface of the glass substrate 60, a seed layer for power feeding is formed, a pattern is formed using a resist, plating at 2 µm or more and 20 µm or less is performed, unnecessary resist pattern is removed, and the seed layer is removed to thereby form an insulating resin.

Since the second wiring layer 22 is not subjected to etching with a hydrogen fluoride aqueous solution in subsequent steps, a material different from the hydrofluoric acid resistant metal can be used. In this case, a metal layer made of a material different from the hydrofluoric acid resistant metal is formed on the side surfaces of the through holes 12. Examples of the material different from the hydrofluoric acid resistant metal include Ti, Cu, and the like, and at least one metal layer made of these materials is formed on the side surfaces of the through holes 12 and on the second surface 30 of the glass substrate 60. The materials, the number of layers, and the like are not limited to the above, and may be appropriately set as necessary.

### (Release of Second Support)

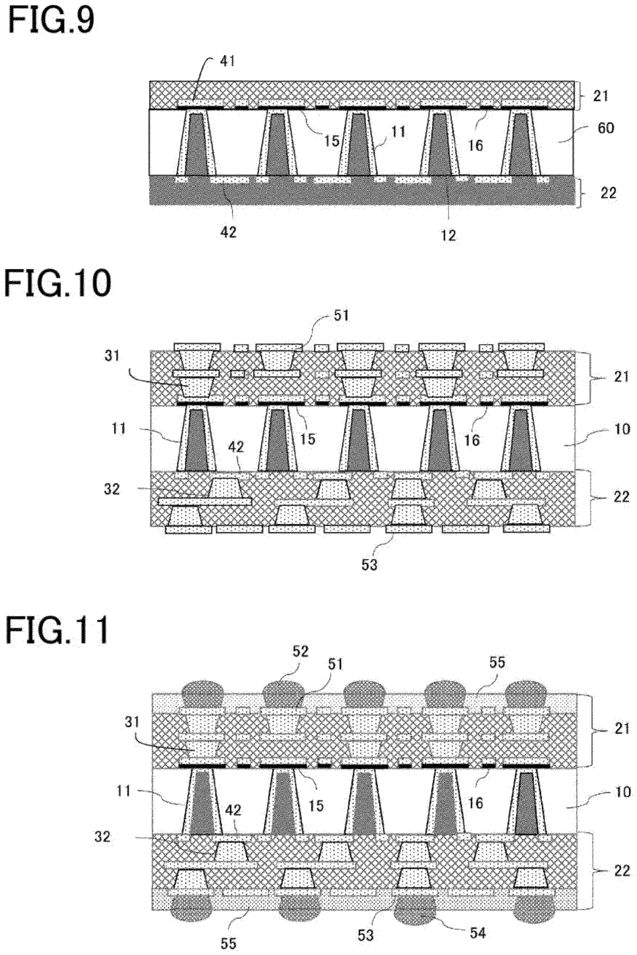

Next, referring to Fig. 8, a step of releasing the second support will be described. As shown in Fig. 8, the second adhesive layer 71 and the second support 70 formed on the upper side of the first wiring layer 21 on the first surface 20 of the glass substrate 60 are released from the interface between the first wiring layer 21 on the first surface and the second adhesive layer 71. Accordingly, as shown in Fig. 9, the glass substrate 60 with the first wiring layer 21 on the first surface 20 of the glass substrate 60 and the second wiring layer 22 on the second surface 30 is obtained.

In release of the second support 70 from the second wiring layer 22, an appropriate release method is selected from UV light irradiation, heating, physical release, and the like depending on the material used for the second adhesive layer 71. Further, when residues of the second adhesive layer 71 are present on the bonding surface between the first wiring layer 21 and the second adhesive layer 71, plasma cleaning, ultrasonic cleaning, water cleaning, solvent cleaning using alcohol, or the like may be performed.

### (Formation of Build-Up Layer)

Next, referring to Fig. 10, a step of forming a build-up layer will be described.

As shown in Fig. 10, conductive electrodes 31 and conductive electrodes 32 are formed in the first wiring layer 21 on the first surface 20 of the glass substrate 60 and the second wiring layer 22 on the second surface 30 to electrically connect the first wiring layer on the first surface and the second wiring layer on the second surface, respectively. The conductive electrodes 31 and 32 are formed by forming vias in the insulating resin layer 25 by laser irradiation, forming a seed layer on the vias, and then performing a semi-additive process (resist pattern formation, plating, resist removal, seed layer removal, insulating resin layer 25).

At least one layer of each of the first wiring layer 21 and second wiring layer 22 are laminated, and the number of layers can be appropriately set as necessary.

The laser used to form the conductive electrodes 31 and the conductive electrodes 32 is different from the laser used to form the laser-modified portions 65. For example, a pulse laser such as a carbon dioxide gas laser or a UV-YAG laser is preferably used, and a µs pulse width laser is suitable.

Next, as shown in Fig. 11, after an outer layer protective film such as a solder resist 55 is formed on each of the first wiring layer 21 and the second wiring layer 22, semiconductor element bonding pads 51 and substrate bonding pads 53 are subjected to surface treatment such as Ni/Au, Ni/Pd/Au, IT, OSP (water soluble preflux), or the like to form semiconductor element bonding solder 52 and substrate bonding solder 54 as necessary, whereby the multilayer wiring board is completed.

### <Second Embodiment>

Next, referring to Figs. 1, 12, 13 and 4 to 11, a second embodiment will be described.

The second embodiment differs from the first embodiment in that the laser modification step is performed after forming the first wiring layer.

In the following description, components that are the same or equivalent to those in the first embodiment described above are denoted by the same reference signs, and the description thereof will be simplified or omitted.

### (Adhesion of First Support)

In a method of producing a multilayer wiring board according to the second embodiment, a step of adhering a first support, which is a first step, is the same as that in the first embodiment described referring to Fig. 1, so the description thereof will be omitted.

### (Formation of First Wiring Layer)

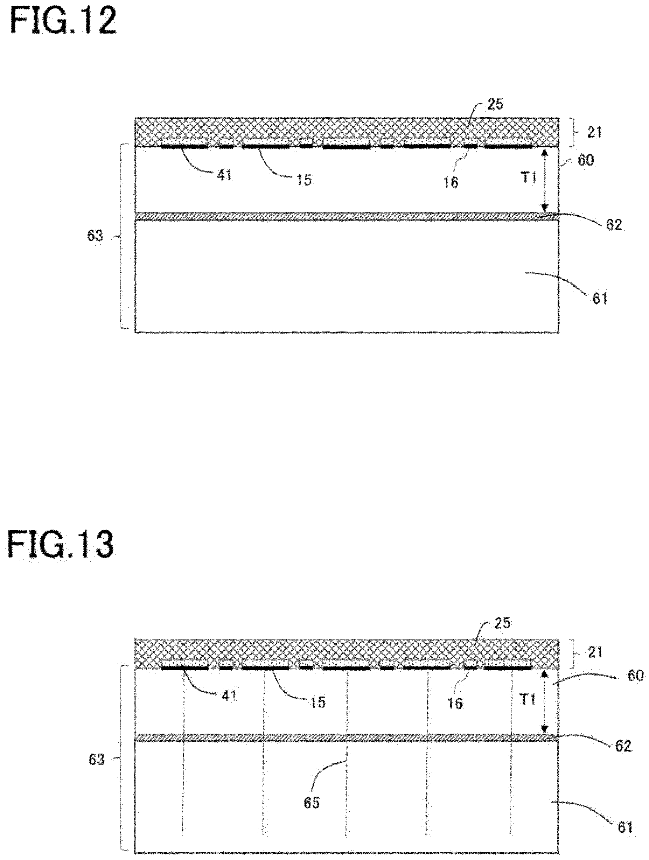

Next, referring to Fig. 12, a step of forming a wiring layer in the second embodiment will be described.

In the second embodiment, subsequent to the step of adhering a first support, a first wiring layer 21 is formed on the glass substrate 60 of the laminate structure 63 as shown in Fig. 12. Specifically, after a seed layer including a hydrofluoric acid resistant metal layer 15 is formed on the glass substrate 60, through-electrode connecting sections 41 and wirings 16 between the through-electrodes are formed by a semi-additive process (SAP), and an unnecessary seed layer is removed to thereby form an insulating resin layer 25.

The materials and film formation methods for the hydrofluoric acid resistant metal layer and the conductive metallic film are the same as those in the first embodiment.

### (Formation of Laser-Modified Portions)

Next, referring to Fig. 13, a step of forming laser-modified portions in the second embodiment will be described. As shown in Fig. 13, a surface of the first support 61 of the laminate structure 63 is irradiated with a laser to form laser-modified portions 65 that serve as starting points of through holes. The laser-modified portions 65 may extend, for example, in a direction perpendicular to the glass substrate 60, and are formed over the entire surface of the glass substrate 60. Here, the laser-modified portions 65 may also be formed in the first adhesive layer 62 and the first support 61.

### (Steps Subsequent to Adhesion of Second Support)

In the second embodiment, steps subsequent to adhesion of the second support, that is, release of the first support, formation of the through holes by etching, formation of the second wiring layer, release of the second support, and formation of the build-up layer, are the same as those in the first embodiment described referring to Figs. 4 to 11, so the description thereof will be omitted.

### <Third Embodiment>

Next, referring to Figs. 1, 12, 14, 15 and 5 to 11, a third embodiment will be described.

The third embodiment differs from the second embodiment in that the laser modification step is performed after adhering the second support.

In the following description, components that are the same or equivalent to those in the first and second embodiments described above are denoted by the same reference signs, and the description thereof will be simplified or omitted.

### (Adhesion of First Support and Formation of First Wiring Layer)

In a method of producing a glass multilayer wiring board according to the third embodiment, a step of adhering a first support, which is a first step, and a step of forming a first wiring layer are the same as those in the second embodiment described referring to Figs. 1 and 12, so the description thereof will be omitted.

### (Adhesion of Second Support)

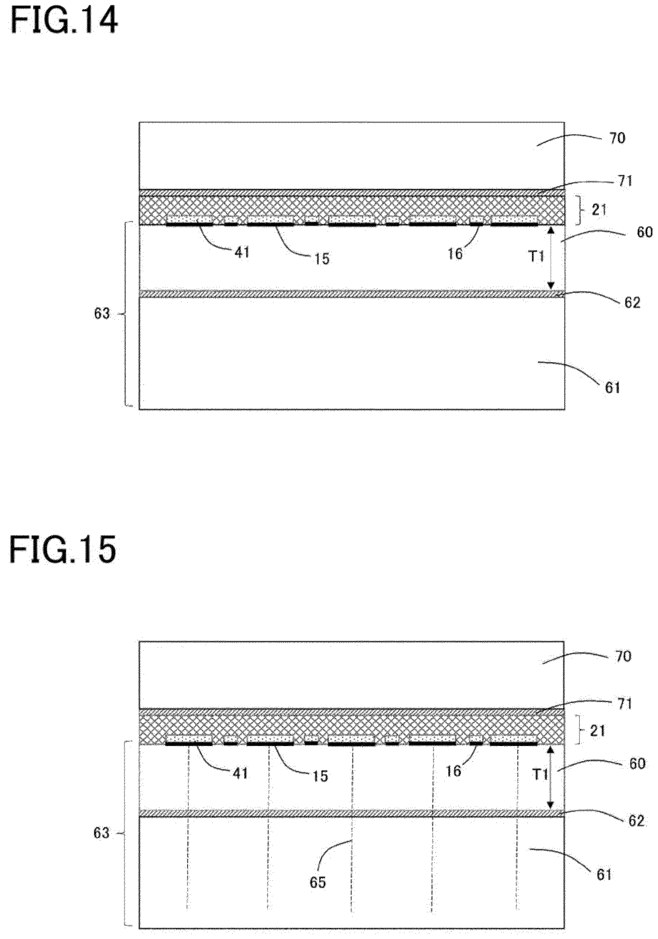

Next, referring to Fig. 14, a step of adhering a second support in the third embodiment will be described.

In the third embodiment, as shown in Fig. 14, a second adhesive layer 71 and a second support 70 are formed on the first wiring layer 21 of the laminate structure 63.

### (Formation of Laser-Modified Portions)

Then, as shown in Fig. 15, the laminate structure 63 is irradiated with a laser to form laser-modified portions 65 that serve as starting points of through holes. The laser-modified portions 65 may extend, for example, in a direction perpendicular to the glass substrate 60, and are formed over the entire surface of the glass substrate 60. Here, the laser-modified portions 65 may also be formed in the first adhesive layer 62 and the first support 61.

### (Steps Subsequent to Release of First Support)

In the third embodiment, steps subsequent to release of the first support, that is, formation of the through holes by etching, formation of the second wiring layer, release of the second support, and formation of the build-up layer, are the same as those in the first embodiment described referring to Figs. 5 to 11, so the description thereof will be omitted.

### <Advantageous Effects>

According to the production methods described in the first to third embodiments, not only the glass substrate 60, but also the support made of the same material as that of the glass substrate 60 are always irradiated with a laser to form laser-modified portions. Therefore, the laser-modified portions can be reliably formed across the entire thickness (z axis direction) of the glass substrate 60. That is, ends of the laser-modified portions, which are portions in which laser modification may be insufficient, are located in the support. Such unstable laser-modified portions are released and removed together with the support in a later step. As a result, the laser-modified portions formed in the glass substrate 60 are highly uniform and precise, and subsequent etching can form uniform through holes.

In the conventional technique, in which only the glass substrate 60 is irradiated with a laser, the laser-modified portions near the surface of the glass substrate are not necessarily uniform, resulting in variations in the shape of the through holes. However, according to the method of forming a multilayer wiring of the present disclosure, this can be greatly improved.

### <Glass Multilayer Wiring Board According to Embodiments of Present Invention>

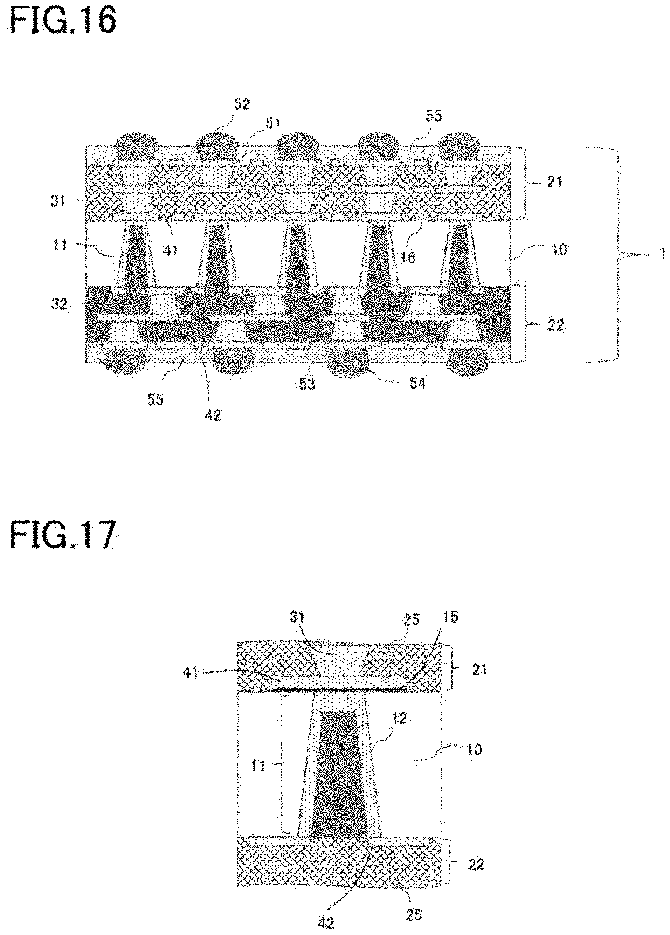

Referring to Figs. 16, 17 and 18, the structure of the multilayer wiring boards produced in the first, second and third embodiments will be described.

In the multilayer wiring boards produced in the first to third embodiments of the present invention, the first wiring layer 21 on the first surface 20 of the glass substrate 60 and the second wiring layer 22 on the second surface 30 are electrically connected to each other via through-electrodes 11 having a frusto-conical shape as shown in Figs. 16, 17 and 18.

The first wiring layer 21 on the first surface 20 and the through-electrodes 11 have a structure in which the through-electrodes 11 are closed by the through-electrode connecting sections 41 of the first wiring layer 21 on the first surface 20, with the hydrofluoric acid resistant metal layer 15 sandwiched between the through-electrode connecting sections 41 and the through-electrodes 11.

The conductive electrodes 31 connecting the first wiring layer 21 on the first surface 20 are formed on the through-electrode connecting sections 41 of the first wiring layer on the first surface 20. The conductive electrodes 32 connecting the second wiring layer 22 on the second surface 30 are formed at positions away from the through-electrodes 11. The conductive electrodes 31 connecting the first wiring layer 21 on the first surface 20 can be formed on the through-electrodes 11 by forming the first wiring layer 21 on the first surface 20 of the glass substrate 60 and then forming the through holes 12 by etching, whereby the wirings 16 can be formed between the through-electrodes 11 in the first wiring layer on the first surface. The first wiring layer 21 on the first surface has a higher degree of freedom in wiring design than the second wiring layer 22 on the second surface.

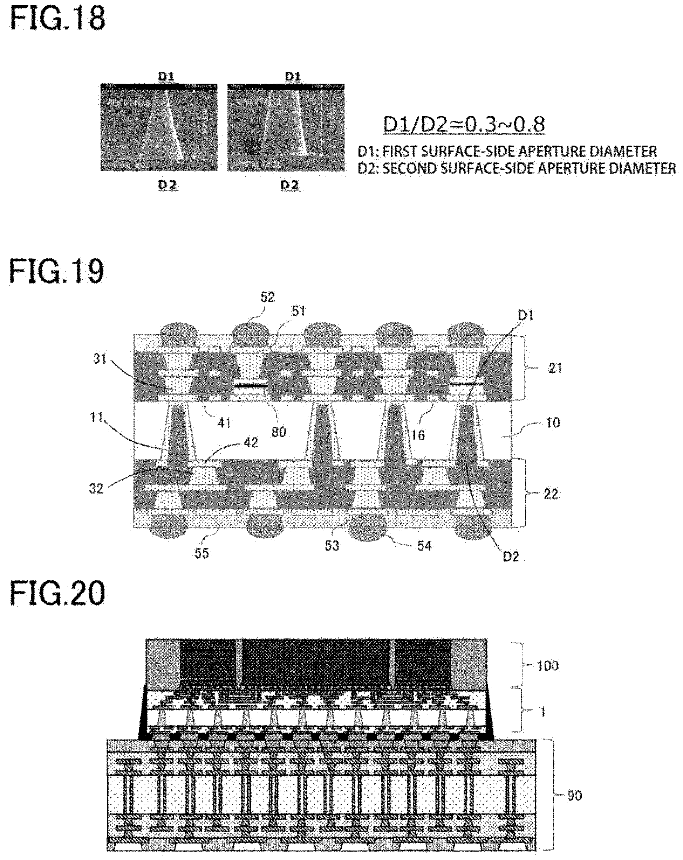

Further, according to the present invention, an aperture diameter D2 in the second wiring layer 22 on the second surface 30 can be stably formed, preventing problems of the aperture diameter D2 being reduced. As shown in Fig. 18, in the through holes 12, that is, the through-electrodes 11, the relationship between an aperture diameter D1 in the first wiring layer 21 on the first surface 20 of the glass substrate 60 and the aperture diameter D2 in the second wiring layer 22 on the second surface 30 is D2>D1, and when the aperture diameter D1 on first surface 20/aperture D2 on the second surface is in the range of approximately 0.3 to 0.8, it is possible to ensure the throwing power of the seed layer on the side surface and bottom of the through-electrodes 11. This ensures adhesiveness on the side surface and bottom of the through-electrodes 11, resulting in high bonding reliability

The above-mentioned methods of producing a glass multilayer wiring board using a thin glass with a glass thickness of 150 µm or less can be used for devices such as a glass multilayer wiring board for passive components with built-in capacitor structures as shown in Fig. 19 and an interposer on which a plurality of semiconductor elements are mounted as shown in Fig. 20. The present embodiment, which facilitates the use of a thin glass with a glass thickness of 150 µm or less and makes it possible to easily form through holes and through-electrodes, can be used for various devices that use a glass multilayer wiring board having through-electrodes.

### <Multilayer Wiring Board>

The present invention includes multilayer wiring boards produced by the above-mentioned methods of producing a multilayer wiring board.

In the multilayer wiring board produced by the production method described in PTL 1, the first surface-side aperture diameters of apertures of the holes and the second surface-side aperture diameters of apertures of the holes are in the range of approximately ±15% to ±20% from their respective average values. On the other hand, in the multilayer wiring board produced by the production method of the present invention, the first surface-side aperture diameters of apertures of the holes and the second surface-side aperture diameters of apertures of the holes are within around ±5% from their respective average values. Therefore, the present invention includes a multilayer wiring board including a glass substrate having a first surface and a second surface, the glass substrate having holes penetrating between the first surface and the second surface, wherein the first surface-side aperture diameters of apertures of the holes and the second surface-side aperture diameters of apertures of the holes are within ±10% from their respective average values.

Further, as described above, the present invention includes a multilayer wiring board, wherein one of the average values of the first surface-side aperture diameters of the apertures of the holes and the second surface-side aperture diameters of the apertures of the holes is smaller than the other, and a ratio between the average values is 0.3 or greater and 0.8 or less.

Further, the present invention includes a multilayer wiring board, wherein the first surface-side apertures of the holes or the second surface-side apertures of the holes, whichever is smaller in aperture diameter, are at least partially closed by a film structure made of a material resistant to hydrofluoric acid corrosion (for example, hydrofluoric acid resistant metal layer 15).

The scope of the present invention is not limited to the example embodiments shown and described, but includes various modifications. For example, the above embodiments have been described in detail in order to facilitate understanding of the present invention, but the present invention is not necessarily limited to those having all the configurations described.

Further, some of the configurations of one embodiment can be replaced with a configuration of another embodiment, and a configuration of one embodiment can include a configuration of one or more other embodiments. Further, some of the configurations of each embodiment can be added, deleted or replaced with other configurations.

Furthermore, the present invention includes all embodiments that provide effects equivalent to those intended by the present invention.

### [Reference Signs List]

1: Glass multilayer wiring board,
11: Through electrode,
12: Through hole,
15: Hydrofluoric acid resistant metal layer,
16: Wiring,
21: First wiring layer,
22: Second wiring layer,
25: Insulating resin layer,
31: Conductive electrode,
32: Conductive electrode,
41: Through electrode connecting section,
42: Through electrode connecting section,
51: Semiconductor element bonding pad,
52: Semiconductor element bonding solder,
53: Substrate bonding pad,
54: Substrate bonding solder,
55: Solder resist,
60: Glass substrate,
61: First support,
62: First adhesive layer,
63: Laminate structure,
65: Laser-modified portion,
70: Second support,
71: Second adhesive layer,
80: Capacitor structure,
90: BGA substrate,
100: Semiconductor element,
D1: First surface-side aperture diameter of through hole
D2: Second surface-side aperture diameter of through hole

## Claims

1. A method of producing a multilayer wiring board including a glass substrate having through holes, the glass substrate having a first surface and a second surface, the method comprising:
a first step of adhering a first support made of glass to the second surface of the glass substrate;
a second step of forming modified portions in the glass substrate and the first support by laser irradiation;
a third step of releasing and removing the first support; and
a fourth step of forming through holes in the glass substrate by etching.

2. The method of producing a multilayer wiring board according to claim 1, wherein
the second step of forming modified portions is performed after forming a first wiring layer on the first surface of the glass substrate.

3. The method of producing a multilayer wiring board according to claim 1, wherein
the second step of forming modified portions is performed after forming a first wiring layer on an upper side of the first surface of the glass substrate and adhering a second support to an upper side of the first wiring layer.

4. The method of producing a multilayer wiring board according to any one of claims 1 to 3, further comprising:
after the fourth step of forming through holes, a fifth step of forming a second wiring layer on a lower side of the second surface of the glass substrate from which the first support has been released and removed; and
a sixth step of releasing and removing the second support.

5. The method of producing a multilayer wiring board according to claim 4, further comprising:
after the sixth step of releasing and removing the second support,
a step of forming a build-up layer on an upper side and/or a lower side of the glass substrate.

6. A multilayer wiring board produced by the method of producing a multilayer wiring board according any one of claims 1 to 5.

7. A multilayer wiring board comprising a glass substrate having a first surface and a second surface, the glass substrate having holes penetrating between the first surface and the second surface, wherein
first surface-side aperture diameters of apertures of the holes and second surface-side aperture diameters of apertures of the holes are within ±10% from their respective average values.

8. The multilayer wiring board according to claim 7, wherein
one of the average values of the first surface-side aperture diameters of the apertures of the holes and the second surface-side aperture diameters of the apertures of the holes is smaller than the other, and a ratio between the average values is 0.3 or greater and 0.8 or less.

9. The multilayer wiring board according to claim 8, wherein
the first surface-side apertures of the holes or the second surface-side apertures of the holes, whichever is smaller in aperture diameter, are at least partially closed by a film structure made of a material resistant to hydrofluoric acid corrosion.
